# EUROPÄISCHE PATENTANMELDUNG

(11) **EP 4 450 980 A1**
(43) Veröffentlichungstag der Anmeldung: **23.10.2024**
(21) Anmeldenummer: 24167607.1
(22) Anmeldetag: 28.03.2024
(51) Int. Cl.: G01R 27/02, G01R 31/58

(54) **VERFAHREN SOWIE ANLAGE ZUR ÜBERPRÜFUNG DER SPANNUNGSFESTIGKEIT EINER ISOLIERUNG EINES ELEKTRISCHEN KABELSATZES**

(30) Priorität: 18.04.2023 DE 102023203537
(71) Anmelder: LEONI Bordnetz-Systeme GmbH, 97318 Kitzingen (DE)
(72) Erfinder: GÜR, Tuncer, 97078 Würzburg (DE)
(74) Vertreter: FDST Patentanwälte

(57) **Zusammenfassung**

Die Erfindung betrifft ein Verfahren sowie eine Anlage zur Überprüfung der Spannungsfestigkeit einer Isolierung eines elektrischen Kabelsatzes (2), welcher zumindest eine Leitung (4) mit einem von einem Isoliermantel (11) umgebenen Leiter (6) aufweist, wobei zwischen einer Prüfsonde (24) und dem Leiter (6) eine Prüfspannung (V) angelegt wird. Die Prüfsonde (24) ist an einer insbesondere als Roboter (20) ausgebildeten Verstellvorrichtung (20) angebracht. Im Rahmen eines Messzyklus fährt die Verstellvorrichtung (20) zumindest mehrere Messpunkte am Kabelsatz (2) mit der Prüfsonde (24) an und zumindest an den mehreren Messpunkten wird die Spannungsfestigkeit der Isolierung überprüft. Bevorzugt wird die Prüfspannung (V) und / oder eine Anpresskraft (F) auf abschnittsspezifische, unterschiedliche Sollwerte geregelt.

## Beschreibung

Die Erfindung betrifft ein Verfahren sowie eine Anlage zur Überprüfung der Spannungsfestigkeit einer Isolierung eines elektrischen Kabelsatzes, welcher zumindest eine Leitung mit einem von einem Isoliermantel umgebenen Leiter aufweist, wobei eine Prüfsonde vorgesehen ist und zwischen der Prüfsonde und dem Leiter eine Prüfspannung angelegt wird, um die Spannungsfestigkeit der Isolierung zu überprüfen.

Bei Kabelsätzen, speziell bei Hochvolt-Kabelsätzen und insbesondere bei Kabelsätzen im Kraftfahrzeugbereich ist am Ende der Fertigung der Kabelsätze regelmäßig eine Sicherheits- und Qualitätsprüfung erforderlich (sogenannte "end of line"-Prüfung). Bei dieser wird die Integrität der Isolierung überprüft. Hierzu wird überprüft, ob die Isolierung des Kabelsatzes einen vorgegebenen Isolationswiderstand und damit eine geforderte Spannungsfestigkeit aufweist. Üblicherweise ist gefordert, dass der Kabelsatz an einem Prüftisch in der späteren Verbaulage im Fahrzeug überprüft wird.

Bei den Kabelsätzen handelt es sich regelmäßig um vorkonfektionierte, oftmals verzweigte Kabelsätze, bei denen an der zumindest einen Leitung bereits weitere elektrische Komponenten, wie beispielsweise ein Stecker, eine Steuerbox oder eine Sicherungsbox angeschlossen sind.

Sofern vorliegend von Hochvolt-Kabelsatz oder Hochvolt-Leitung gesprochen wird, so wird hierunter verstanden, dass der Kabelsatz für eine Betriebsspannung von mehr als 30V bei Wechselspannung und von mehr als 60V bei Gleichspannung ausgelegt ist und im Betrieb derartige Spannungen anliegen. Drüber hinaus ist der Kabelsatz insbesondere auch für Spannungen von mehreren 100 V, beispielsweise von mehr als 200V bis hin zu 1000 V ausgebildet ist. Derartige Hochvolt-Kabelsätze werden speziell bei elektromotorisch angetriebenen Kraftfahrzeugen eingesetzt, um Komponenten des elektrischen Antriebs, wie beispielsweise Hochvolt-Batterie, elektrischer Fahrmotor, gegebenenfalls Wechselrichter usw. miteinander zu verbinden.

Bei geschirmten Leitungen erfolgt eine Prüfung der Spannungsfestigkeit beispielsweise dadurch, dass eine Prüfspannung zwischen einer Schirmung und dem innenliegenden Leiter angelegt wird. Die Prüfung einer geschirmten Leitung wird beispielsweise in der DE 10 2017 005 306 A1 beschrieben. Eine derartige Prüfung ist jedoch bei ungeschirmten Leitungen nicht möglich.

In der DE 10 2019 210 866 A1 wird eine Prüftasche beschrieben, in die der zu überprüfende Kabelsatz eingelegt wird und die eine elektrisch leitfähige Hülle aufweist. Zwischen der Hülle und dem zumindest einen Leiter des Kabelsatzes wird eine Prüfspannung angelegt. Um ein möglichst enges Anliegen der Hülle am Kabelsatz zu gewährleisten kann die Luft aus der Prüftasche abgesaugt werden.

Aus der DE 10 2020 101 432 A1 ist ein Verfahren zur Prüfung der Spannungsfestigkeit eines Hochvolt-Leitungssatzes zu entnehmen, bei dem ein zweiteiliges Gehäuse mit flexiblen Kontaktnetzen vorgesehen ist, wobei der Leitungssatz zwischen die beiden Gehäusehälften eingelegt wird.

Darüber hinaus ist es auch bekannt, bei endlosen Leitungen diese kontinuierlich zu prüfen. So ist beispielsweise gemäß der GB 848 180 A eine Anlage vorgesehen, bei der eine Leitung von einer Vorratsspule abgewickelt, durch eine Prüfvorrichtung hindurchgeführt und anschließend wieder aufgewickelt wird. Bei der Prüfvorrichtung handelt es sich um ein mit einem Prüfgas gefülltes Rohr, in das eine Prüfelektrode eintaucht, an die eine Prüfspannung angelegt wird. Bei einer schadhaften Isolierung erfolgt eine Ionisierung, die bei dieser Anlage auch akustisch dargestellt wird. Aus der GB 991 686 A ist eine vergleichbare Anlage zu entnehmen.

Daneben sind auch Druckluftprüfungen möglich, bei denen zwischen dem Isoliermantel und dem Leiter Druckluft eingebracht wird, um über die Messung eines Druckverlustes eine Beschädigung der Isolierung zu erkennen. Hierbei können jedoch Mikrorisse und oberflächliche Beschädigungen nicht erkannt werden.

Auch besteht die Möglichkeit, den Kabelsatz in einer mit leitfähigem Gas gefüllten Kammer zu überprüfen. Dies ist jedoch bei großen Kabelsätzen nur mit hohem Aufwand möglich, auch müssten dort die angelegten Spannungen sehr hoch sein, um überhaupt Beschädigungen detektieren zu können. Schließlich besteht auch die Möglichkeit, den Kabelsatz in ein Salzwasserbad zu tauchen, was jedoch zu Salzwasserrückständen und eventuell auch zu Beschädigungen des Kabelsatzes führt.

Ausgehend hiervon liegt der Erfindung die Aufgabe zugrunde, ein Verfahren sowie eine Anlage zur Überprüfung der Spannungsfestigkeit eines Kabelsatzes, insbesondere eines Hochvolt-Kabelsatzes für ein Kraftfahrzeug anzugeben, welche kostengünstig und mit geringem Aufwand für eine Serienprüfung geeignet sind.

Die Aufgabe wird gemäß der Erfindung gelöst durch ein Verfahren sowie eine Anlage zur Überprüfung der Spannungsfestigkeit der Isolierung eines elektrischen Kabelsatzes, insbesondere eines Hochvolt-Kabelsatzes, und speziell eines solchen Kabelsatzes für ein Kraftfahrzeug.

Der Kabelsatz weist zumindest eine (Hochvolt-) Leitung mit einem von einem Isoliermantel umgebenen Leiter auf. Es ist eine Prüfsonde vorgesehen, wobei zwischen der Prüfsonde und dem Leiter eine Prüfspannung angelegt wird. Die Prüfsonde ist an einer Verstellvorrichtung angebracht und im Rahmen eines Messzykluses zur Überprüfung der Spannungsfestigkeit fährt die Verstellvorrichtung zusammen mit der Prüfsonde zumindest mehrere Messpunkte am Kabelsatz an und an den zumindest mehreren Messpunkten wird die Spannungsfestigkeit der Isolierung überprüft. Für das Verfahren der Prüfsonde weist die Anlage eine Steuereinheit auf, die dazu eingerichtet ist die Verstellvorrichtung und damit die Prüfsonde an die zumindest mehreren Messpunkte am Kabelsatz zu verfahren.

Die eigentliche Prüfung erfolgt in bekannter Weise durch Anlegen der Prüfspannung zwischen dem Leiter und der Prüfsonde, sodass also über die Isolierung hinweg eine Spannungsdifferenz anliegt. Die Anlage weist hierzu unter anderem ein Anschlussterminal auf, an dem der Leiter elektrisch angeschlossen wird.

Die Anlage weist weiterhin eine Prüfeinheit auf, die zum Erzeugen und Anlegen der Prüfspannung zwischen dem Anschlussterminal und der Prüfsonde ausgebildet ist. Diese Prüfspannung wird mithilfe einer geeigneten Auswerteeinrichtung speziell im Hinblick auf einen Spannungseinbruch überprüft. Diese Auswerteeinrichtung ist insbesondere ein Bestandteil der Prüfeinheit, sie bildet mit dieser vorzugsweise eine Baueinheit. Mithilfe der Auswerteeinrichtung erfolgt daher allgemein zunächst eine Messung und Überprüfung/Überwachung der anliegenden Prüfspannung zwischen Prüfsonde und Leiter. Im Falle einer schadhaften Isolierung erfolgt quasi eine Entladung oder ein Lichtbogen zwischen den beiden Prüfelektroden, die einerseits durch den Leiter und andererseits durch die Prüfsonde gebildet sind. Ein derartiger Lichtbogen und damit Spannungseinbruch wird von der Auswerteeinheit erfasst. Die Auswerteeinrichtung ist daher zur Überprüfung der Spannungsfestigkeit ausgebildet. Bei Erkennen einer mangelnden Spannungsfestigkeit gibt sie ein Warnsignal ab. Die angelegte Prüfspannung liegt vorzugsweise im Bereich von größer 1 kV und beispielsweise im Bereich zwischen 1 kV und 5 kV.

Bei dem zu prüfenden Kabelsatz handelt es sich insbesondere um einen Hochvolt-Kabelsatz für ein Kraftfahrzeug, welcher im Betrieb daher in einem Kraftfahrzeug eingebaut ist. Speziell dient der Kabelsatz zur Verbindung von Komponenten eines elektrischen Fahrantriebs des Kraftfahrzeugs.

Bei der zumindest einen Leitung handelt es sich insbesondere um eine einadrige Mantelleitung, die also lediglich einen zentralen Leiter (Leitungsader) aufweist, der von einem Adermantel umgeben ist, welcher zumindest abschnittsweise den Isoliermantel bildet. Zumindest in diesen Abschnitten besteht die Leitung ausschließlich aus dem Leiter und dem Isoliermantel. In einigen Varianten ist der Adermantel abschnittsweise noch von einer schlauchartigen Schutzhülle umgeben, die dann einen Teil des Isoliermantels bildet. Bevorzugt weist der Kabelsatz insbesondere zwei derartige Leitungen auf, die im Betrieb als Plusleitung und Minusleitung (Masseleitung) eines Gleichstrom-Kabelsatzes eingesetzt sind.

Allgemein handelt es sich bei der Leitung bevorzugt um eine ungeschirmte Leitung.

Durch die Anordnung der Prüfsonde an der Verstellvorrichtung besteht die einfache Möglichkeit, die Prüfsonde entlang des Kabelsatzes zu verfahren. Durch die Verstellvorrichtung wird daher die Prüfsonde im Raum bewegt und relativ zum Kabelsatz verfahren. Der Kabelsatz ist dabei insbesondere ortsfest positioniert. Hierdurch kann gezielt auch eine komplexe Geometrie des Kabelsatzes abgefahren werden, sodass eine zuverlässige Überprüfung des Kabelsatzes mit geringem Aufwand erreicht ist. Mithilfe der Verstellvorrichtung wird die Prüfsonde an den mehreren Messpunkten gegen die Isolierung verfahren und insbesondere gegen diese gedrückt. Der zu überprüfende Kabelsatz ist beispielsweise in einer geeigneten Vorrichtung eingespannt oder liegt auf einer festen Unterlage auf.

Bei diesem Verfahren sind keine weiteren Maßnahmen wie Prüftaschen, Prüfrohre oder sonstige Prüfhüllen oder Prüfkammern vorgesehen. Auch wird auf die Verwendung von Prüfgasen verzichtet. Der Kabelsatz wird auch nicht in ein Bad eingetaucht.

Die Prüfsonde bildet eine Art Prüf- oder Messelektrode aus. Ein Vorteil ist darin zu sehen, dass lediglich lokal am Ort der Prüfsonde die Spannungsdifferenz anliegt und überprüft wird.

Durch dieses Verfahren ist in einfacher Weise auch eine ortsaufgelöste Prüfung ermöglicht und wird durchgeführt. Hierunter wird insbesondere verstanden, dass bei der Durchführung der Prüfung die Ortsinformation der Prüfsonde erfasst und abgespeichert wird. Im Falle der Identifizierung einer Schadstelle der Isolierung wird daher unmittelbar auch der Ort der Schadstelle ermittelt und identifiziert.

Bevorzugt wird die Prüfsonde entlang von zumindest einem Prüfabschnitt des Kabelsatzes an diesem entlang verfahren. Die Spannungsfestigkeit wird dabei über die Länge des Prüfabschnittes kontinuierlich überprüft. Die Prüfsonde wird an die Isolierung herangefahren und an diese angedrückt. Während sie an der Isolierung entlang gleitet wird kontinuierlich die Prüfspannung angelegt und ausgewertet. Die Länge des Prüfabschnitts liegt insbesondere im Bereich von mehreren Zentimetern, weiter vorzugsweise im Bereich von mehr als 10 cm. Insbesondere erstreckt sich der Prüfabschnitt über zumindest einen Großteil der Länge der Leitung, Beispielweise über zumindest 50 % oder zumindest 75 % der Leitung. In zweckdienlicher Ausgestaltung wird die Prüfsonde kontinuierlich entlang der gesamten Leitungslänge verfahren und weiter vorzugsweise auch über die gesamte Länge des Kabelsatzes. Hierdurch ist eine insbesondere vollständige Überprüfung des Isoliermantels der Leitung insbesondere auch der Isolierung des gesamten Kabelsatzes erzielt.

Die Prüfsonde wird in bevorzugter Ausgestaltung mit einer definierten, vorgegebenen Anpresskraft gegen die Isolierung des Kabelsatzes und insbesondere gegen den Isoliermantel der Leitung gedrückt. Hierdurch sind definierte Prüfbedingungen gewährleistet und insbesondere ist gewährleistet, dass die Prüfsonde zuverlässig an der Isolierung anliegt. Der Abstand zwischen der Prüfsonde und dem Leiter, ist auf ein Minimum reduziert, wobei der Abstand insbesondere durch die Mantelwandstärke des Isoliermantels gebildet ist.

In bevorzugter Ausgestaltung wird die ausgeübte Anpresskraft mit einer geeigneten Messeinrichtung erfasst und insbesondere direkt gemessen. Die Messeinrichtung ist beispielsweise in der Prüfsonde integriert oder Teil der Verstellvorrichtung. Sie ist speziell als Kraftsensor ausgebildet. Bei einer Integration in der Prüfsonde ist diese daher nach Art einer taktilen Messspitze ausgebildet, die eine Doppelfunktion aufweist, nämlich die Anlegung der Prüfspannung sowie die Messung der Anpresskraft.

Bevorzugt wird in Abhängigkeit der ermittelten Anpresskraft diese gesteuert und eingestellt. Die Anpresskraft wird daher insbesondere kontinuierlich überprüft und sofern der aktuelle Istwert von einem Sollwert abweicht wird die Anpresskraft geeignet eingestellt. Dies erfolgt insbesondere über eine geeignete Ansteuerung der Verstellvorrichtung, über die die Anpresskraft typischerweise ausgeübt wird. Durch die Steuerung und insbesondere Regelung der Anpresskraft wird ein schonendes, definiertes Anpressen der Prüfsonde ohne Beschädigung des Kabelsatzes gewährleistet.

In bevorzugter Weiterbildung wird während des Messzykluses der Wert zumindest eines Prüfparameters ausgewählt aus Prüfspannung und Anpresskraft variiert. Durch die Variation werden die Prüfbedingungen also im Rahmen eines Messzykluses insbesondere in Abhängigkeit der Eigenschaften des Kabelsatzes oder in Abhängigkeit der Position der Prüfsonde variiert. Dies beruht auf der Überlegung, dass über die Länge des Kabelsatzes unterschiedliche Abschnitte existieren, die sich entweder im Hinblick auf ihren Aufbau unterscheiden und/oder im Hinblick auf ein Gefährdungspotenzial für Schäden an der Isolierung, beispielsweise in Folge von Montagevorgängen. Bevorzugt werden definierte, insbesondere kritische Abschnitte identifiziert, bei denen die Prüfspannung und/oder die Anpresskraft gegenüber weiteren Abschnitten verändert und insbesondere erhöht werden. In kritischen Isolierbereichen werden bevorzugt gezielt die Prüfbedingungen verschärft, so dass beispielsweise auch bereits Mikrorisse in der Isolierung identifiziert werden können.

Die Werte der Prüfparameter werden in bevorzugter Ausgestaltung also allgemein ortsabhängig entlang des Kabelsatzes variiert.

In zweckdienlicher Weiterbildung ist eine Erkennungseinheit vorgesehen, mit deren Hilfe unterschiedliche Abschnitte des Kabelsatzes identifiziert werden, wobei der Wert des zumindest einen Prüfparameters in Abhängigkeit der von der Erkennungseinheit ermittelten Informationen gesteuert wird. Während der Durchführung des Messzykluses wird daher insbesondere kontinuierlich die Position der Prüfsonde in Relation zum Kabelsatz ermittelt und/oder die Form, Struktur oder sonstige Eigenschaften des Kabelsatzes werden mithilfe der Erkennungseinheit identifiziert. Bei der Erkennungseinheit handelt es sich insbesondere um eine Kamera, vorzugsweise mit zugehöriger Bildauswertung. Alternativ kann es sich bei der Erkennungseinheit auch um eine Auswerteeinheit handeln, die anhand von aktuellen Positionsdaten der Prüfsonde und durch Abgleich mit hinterlegten Daten zur Struktur des Kabelsatzes die unterschiedlichen Abschnitte des Kabelsatzes identifiziert.

Auf Basis der von der Erkennungseinheit ermittelten Informationen werden in bevorzugter Ausbildung die Prüfparameter automatisch für unterschiedliche Abschnitte unterschiedlich eingestellt.

In bevorzugter Ausgestaltung weist die Leitung einen Schutzabschnitt auf, in dem die Leitung neben dem Adermantel noch eine zusätzliche Schutzhülle aufweist. Diese bildet zusammen mit dem Adermantel den Isoliermantel aus. Die Anpresskraft wird im Bereich des Schutzabschnittes gegenüber (normalen) Abschnitten ohne Schutzhülle vorzugsweise erhöht. Bevorzugt wird ergänzend auch die Prüfspannung in diesem Abschnitt erhöht.

Bei derartigen Schutzhüllen handelt es sich beispielsweise um einen Schutzschlauch, welcher in Teilabschnitten angebracht ist. Hierbei kann zwischen der Schutzhülle und dem Adermantel der Leitung ein (Luft-) Spalt bestehen. Durch die erhöhte Anpresskraft wird gewährleistet, dass die Schutzhülle an den Adermantel angepresst wird und somit unmittelbar an diesem anliegt, was im Hinblick auf eine zuverlässige Prüfung von Vorteil ist.

In bevorzugter Weiterbildung wird in einem Anschlussabschnitt, in dem die Leitung an einer weiteren Komponente angeschlossen ist, die Prüfspannung erhöht, speziell im Vergleich zu einem normalen Abschnitt entfernt von der Komponente und ohne Schutzhülle. Bei einem derartigen Anschlussabschnitt handelt es sich insofern um einen kritischen Abschnitt, da bei der Konfektionierung des Leitungssatzes in diesem Abschnitt spezielle Belastungen auftreten. Diese sind beispielsweise hervorgerufen durch erforderliche Maßnahmen zur Abisolierung und/oder zum Anschluss an Kontaktelementen, sodass in diesem Bereich die Gefahr von Beschädigungen erhöht ist. Durch die Erhöhung der Prüfspannung in diesem speziellen Abschnitt werden daher bewusst die Prüfanforderungen erhöht, um in diesem kritischen Bereich zuverlässig Schädigungen ausschließen zu können.

Allgemein wird bei Erreichen der speziellen Abschnitte, also z.B. des Schutzabschnittes oder des Anschlussabschnittes, der Wert des jeweiligen Prüfparameters auf einen abschnittsspezifischen Sollwert eingestellt, welcher verschieden und insbesondere höher ist im Vergleich zu einem Sollwert für andere (normale) Abschnitte.

Gemäß einer bevorzugten Weiterbildung weist die Leitung einen Biegebereich auf und die Spannungsfestigkeit wird zumindest in diesem gebogenen Bereich geprüft. Insbesondere handelt es sich hierbei bei der Leitung um eine sogenannte isolierte Busbar oder isolierte Stromschiene, die regelmäßig eine hohe Biegesteifigkeit aufweist. Eine solche Busbar besteht üblicherweise aus einem massiven und von dem Isoliermantel umgebenen Leiter. Bei dem Leiter handelt es sich typischerweise um einen Flachleiter mit einer Breite von beispielsweise mehreren Zentimetern (mehr als 2 cm, insbesondere mehr als 4 cm, bei einer Dicke von typischerweise zumindest 5 mm). Allgemein weisen die Busbars beispielsweise eine Querschnittsfläche von zumindest 20mm², von zumindest 25mm² oder auch von zumindest 50mm². Derartige Busbars sind allgemein für die Übertragung von hohen Strömen von typischerweise >50A und insbesondere > 100A ausgebildet.

Beim Herstellen derartiger Busbars werden diese häufig einem Biegeprozess unterzogen, um sie an eine gewünschte Verlegegeometrie anzupassen. Bei diesem Biegeprozess wird der Biegebereich ausgebildet. Aufgrund der mechanischen Belastung durch die Biegung wird der Isoliermantel speziell im Biegebereich beansprucht und kann beschädigt werden. Durch die Prüfung im Biegebereich wird gezielt dieser bei der Herstellung mechanisch belastete Teilabschnitt geprüft.

Beim Kabelsatz handelt es sich insbesondere um einen konfektionieren Kabelsatz, bei dem an der zumindest einen Leitung eine weitere Komponente angeschlossen ist. Bei dieser weiteren Komponente handelt es sich insbesondere um einen Stecker. Alternativ oder auch ergänzend ist als weitere Komponente direkt an der Leitung eine Steuerbox oder eine Sicherungsbox angeschlossen, in denen weitere (elektronische) Bauteile, wie beispielsweise Steuerungselemente, Sicherungselemente oder sonstige elektrische Schaltungsbauteile integriert sind.

In bevorzugter Ausgestaltung weist der Kabelsatz zwei Leitungen und vorzugsweise genau zwei Leitungen auf, die eine Hin- und Rückleitung einer Gleichstromleitung ausbilden. Diese beiden Leitungen sind endseitig und vorzugsweise beidendseitig insbesondere gemeinsam an der elektrischen Komponente angeschlossen. In einer Ausführungsvariante ist der Kabelsatz daher gebildet durch die genau zwei Leitungen mit zumindest einer daran angeschlossenen elektrischen Komponente. Alternativ hierzu ist eine zusätzliche Abzweigleitung vorgesehen, die von diesen beiden zuvor genannten Leitungen, die einen Hauptstrang bilden, abgehen. Allgemein weist der Kabelsatz bei einer Ausgestaltung mit einem Hauptstrang und zumindest einer davon abgehenden Abzweigleitung eine verzweigte Struktur auf.

Die an der zumindest einen Leitung angeschlossene weitere Komponente weist üblicherweise ein Gehäuse auf. Bevorzugt wird die Prüfsonde auch an das Gehäuse verfahren und die Isolationsfestigkeit des Gehäuses wird geprüft. Durch diese Maßnahme wird daher insbesondere der komplette Kabelsatz überprüft.

Bei der Verstellvorrichtung handelt es sich insbesondere um einen Roboter, an dem die Prüfsonde befestigt ist und dessen Bewegungsbahn programmierbar ist. Bei dem Roboter handelt es sich beispielsweise um einen sogenannten mehrachsigen Industrieroboter, wie er bei der industriellen Produktion üblicherweise eingesetzt wird. Der Roboter weist typischerweise mehrere gegeneinander verstellbare Roboterarme auf. Die Prüfsonde ist an einer sogenannten Roboterhand angeordnet. Diese ist durch eine entsprechende Bewegung der unterschiedlichen Roboterarme frei im Raum verfahrbar. Durch die Programmierarbeit der Bewegungsbahn des Roboters ist eine einfache Anpassung an unterschiedliche Kabelsätze ermöglicht. Speziell sind im Steuerprogramm des Roboters unterschiedliche Kabelsatz-Designs hinterlegt, sodass also bei einem Wechsel der Kabelsätze lediglich ein unterschiedliches Steuerprogramm ausgewählt werden muss.

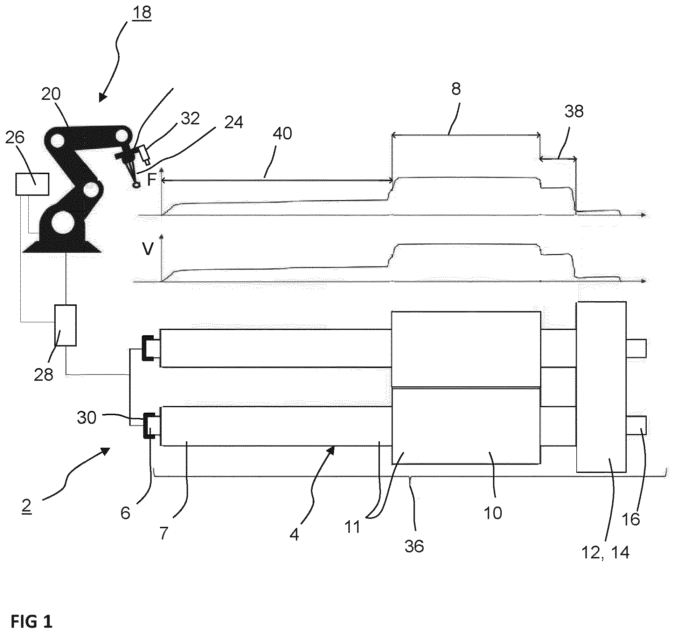

Ein Ausführungsbeispiel der Erfindung wird nachfolgend anhand der einzigen Figur näher erläutert. Diese zeigt in einer vereinfachten, schematisierten Darstellung einen Gleichstrom-Kabelsatz, einen Roboter mit daran befestigter Prüfsonde sowie einen beispielhaften Verlauf einer angelegten Prüfspannung und einer angelegten Anpresskraft entlang der Länge des Kabelsatzes.

Ein in der Figur dargestellter Kabelsatz 2 ist als ein Gleichstrom-Kabelsatz 2 ausgebildet, welcher im Ausführungsbeispiel genau zwei (Hochvolt-) Leitungen 4 aufweist, die im Betrieb und im angeschlossenen Zustand eine Plusleitung sowie eine Minusleitung ausbilden. Eine jeweilige Leitung 4 ist als eine einadrige Leitung ausgebildet und weist einen zentralen Leiter 6 auf, welcher von einem Adermantel 7 umgeben ist.

Im Ausführungsbeispiel weist jede Leitung 4 in einem Schutzabschnitt 8 einen Schutzschlauch auf, welcher eine Schutzhülle 10 ausbildet. Diese bildet zusammen mit dem Adermantel einen den Leiter 6 umgebenden Isoliermantel 11 der Leitung 6 aus.

An einem Ende ist an den beiden Leitungen 4 als elektrische Komponente 12 ein (Hochvolt-) Stecker angeschlossen. Diese weist allgemein ein Gehäuse 14 auf, in welches eine jeweilige Leitung 4 eingeführt ist, insbesondere abgedichtet gegen das Eindringen von Staub- und Feuchtigkeit. Im Inneren der Komponente 12 ist der jeweilige Leiter 6 geeignet kontaktiert. Im Ausführungsbeispiel sind jeweils noch schematisch Kontaktelemente 16 des Steckers dargestellt, mit dem dieser über eine Steckverbindung mit einer weiteren elektrischen Komponente verbunden wird.

Ergänzend ist in der Figur weiterhin eine Anlage 18 dargestellt, die zur Überprüfung der Spannungsfestigkeit einer Isolierung des dargestellten Kabelsatzes 2 ausgebildet ist. Die Isolierung ist dabei insbesondere durch den Isoliermantel 11 gebildet und vorzugsweise ergänzend auch durch das Gehäuse 14 der elektrischen Komponente 12.

Die Anlage 18 weist einen Roboter 20 als eine Verstellvorrichtung auf, welcher als ein mehrachsiger Industrieroboter ausgebildet ist. Dieser weist mehrere Roboterarme auf, die jeweils in bekannter Weise um mehrere Achsen verstellbar sind. An einem vorderen Ende weist der Roboter 20 eine Roboterhand auf, an der eine Prüfsonde 24 angebracht ist. Diese ist mithilfe des Roboters 20 im Raum entlang einer programmierbaren Bewegungsbahn verfahrbar.

Die Anlage 18 weist weiterhin eine Steuereinheit 26 auf, über die die Anlage 18 und insbesondere der Roboter 20 gesteuert wird. Weiterhin umfasst die Anlage 18 eine Prüfeinheit 28 sowie Anschlussterminals 30, an denen jeweils zur Durchführung der Prüfung der jeweilige Leiter 6 angeschlossen wird. Bei den Anschlussterminals 30 handelt es sich beispielsweise um Schraubterminals oder Klemmterminals. Die Prüfeinheit 28 ist dazu ausgebildet, eine Prüfspannung V zu erzeugen und einerseits an die Anschlussterminals 30 sowie andererseits an die Prüfsonde 24 anzulegen, so dass also eine Spannungsdifferenz zwischen der Prüfsonde 24 und dem jeweiligen Leiter 4 besteht. Bei der Prüfsonde 24 handelt es sich um eine Art Messspitze oder auch Elektrode, die gegenüber den Anschlussterminals 30 auf einem vorgegebenen Spannungspotential (Prüfspannung V) liegt. Die Prüfeinheit 28 ist hierzu in geeigneter Weise mit der Prüfsonde 24 über eine elektrische Leitung verbunden.

Die Anlage weist schließlich weiterhin eine Erkennungseinheit 32 auf, die im Ausführungsbeispiel als eine optische Kamera ausgebildet ist. Diese steht insbesondere mit der Steuereinheit 26 in Verbindung.

Weiterhin ist die Anlage 18 zur Erfassung einer Anpresskraft F ausgebildet, mit der die Prüfsonde 24 gegen die Isolierung und speziell gegen den Isoliermantel 11 bei der Durchführung der Prüfung gedrückt wird. Hierzu ist insbesondere ein Kraftsensor 34 angeordnet, welcher beispielsweise an der Roboterhand zwischen dieser und der Prüfsonde 24 angeordnet ist oder in die Prüfsonde 24 integriert ist.

Bei der Durchführung der Überprüfung der Spannungsfestigkeit der Isolierung des Kabelsatzes 2 wird wie folgt vorgegangen:
Mithilfe der Steuereinheit 26 wird der Roboter 20 derart angesteuert, dass die Prüfsonde 24 gegen die Isolierung und speziell gegen den Isoliermantel 11 zunächst der einen der Leitungen 4 wird. Die Prüfsonde 24 wird dabei mittels des Roboters 20 mit einer definierten Anpresskraft F gegen die Isolierung gedrückt. Diese Anpresskraft F wird speziell mithilfe des Kraftsensors 34 gemessen. Die Anpresskraft F wird automatisch auf einen insbesondere variablen Sollwert mithilfe der Steuereinheit 26 geregelt.

Bei der Prüfung wird eine vorgegebene Prüfspannung V zwischen der Prüfsonde 24 und dem jeweiligen Leiter 6 angelegt.

Die Prüfsonde 24 wird dann entlang des Isoliermantels 11 unter Beibehaltung der Anpresskraft F über zumindest eine vorgegebene Länge eines Prüfabschnitts 36 verfahren. Im Ausführungsbeispiel ist der Prüfabschnitt 36 durch die gesamte Länge der Leitung 4 und bei Bedarf auch durch die gesamte Länge des kompletten Kabelsatzes 2, also inklusive der angeschlossenen Komponente 12 gebildet. Die Prüfsonde 24 verfährt kontinuierlich entlang des Prüfabschnittes 36, speziell verfährt die Prüfsonde 24 zumindest entlang der gesamten Länge der jeweiligen Leitung 4.

Die angelegte Prüfspannung V und/oder die angelegte Anpresskraft F bilden Prüfparameter aus, deren Werte im Rahmen des Messzyklus, also bei der Prüfung einer jeweiligen Leitung 4 bzw. bei der Überprüfung des Kabelsatzes 2 automatisch variiert und eingestellt werden. Die Prüfspannung V und / oder die Anpresskraft F werden dabei auf abschnittsspezifische, unterschiedliche Sollwerte geregelt.

So ist beispielsweise in bevorzugter Ausgestaltung vorgesehen, dass zumindest die Prüfspannung V und/oder die Anpresskraft F im Bereich des Schutzabschnitts 8 und der Schutzhülle 10 erhöht wird im Vergleich zu den Bereichen davor ohne Schutzhülle 10.

Der Abschnitt einer jeweiligen Leitung 4 im Bereich vor der elektrischen Komponente 12 bildet einen Anschlussabschnitt 38 aus. In diesem wird insbesondere die Prüfspannung V verändert und insbesondere erhöht im Vergleich zu normalen Abschnitten 40 des Kabelsatzes, die entfernt von der Komponente 12 gelegen sind und bei denen keine Schutzhülle 10 ausgebildet sind.

Ein jeweiliger normaler Abschnitt 40 ist daher dadurch definiert, dass in diesem der Adermantel 7 die äußerste Ummantelung definiert. Weiterhin ist der normale Abschnitt 40 beispielsweise um zumindest 5 cm oder zumindest 10 cm beabstandet von der angeschlossenen Komponente 12 oder einem sonstigen angebrachtem Element wie beispielsweise ein Anschlussterminal. Der Anschlussabschnitt weist insbesondere eine solche Länge von zumindest 5 cm oder zumindest 10 cm und beispielsweise maximal 20 cm auf.

Mithilfe der Erkennungseinheit 32 werden automatisch die unterschiedlichen Abschnitte, also der Schutzabschnitt 8, der Anschlussabschnitt 38 sowie der normale Abschnitt 40 identifiziert und die Prüfparameter werden entsprechend hinterlegten und unterschiedlichen abschnittsspezifischen (Soll-) Werten eingestellt und insbesondere geregelt.

Die Prüfeinheit 28, insbesondere die zuvor erwähnte Auswerteeinheit, überprüft dabei kontinuierlich die angelegte Prüfspannung V im Hinblick auf Abweichungen von dem Sollwert. Im Falle einer schadhaften Isolierung wird dies beispielsweise durch einen Spannungseinbruch erfasst. Die Prüfeinheit 28 ist dazu ausgelegt, bei einer unzulässigen Abweichung ein Warnsignal auszugeben. Dieses weist dabei insbesondere eine Ortsinformation auf, sodass die Position der schadhaften Isolierung exakt bestimmt werden kann. Hierzu erhält die Prüfeinheit 28 beispielsweise Positionsdaten von der Steuereinheit 26.

Innerhalb der Prüfeinheit 28 ist eine Spannungsquelle und bevorzugt auch die erwähnte Auswerteeinheit integriert, die also innerhalb einer gemeinsamen Baueinheit angeordnet sind. Grundsätzlich können die unterschiedlichen erforderlichen Einheiten der Prüfereinheit, wie Spannungsquelle und Auswerteeinheit, auch verteilt auf unterschiedliche Baueinheiten sein. So besteht beispielsweise die Möglichkeit, dass die Auswerteeinheit in der Steuereinheit 26 integriert ist. Die Prüfeinheit 28 kann insgesamt auch innerhalb der Steuereinheit 26 integriert sein.

Die Prüfsonde 24 wird entweder entlang einer geradlinigen linearen Bahn an der jeweiligen Leitung 4 entlang verfahren. In bevorzugter Ausführungsvariante ist vorgesehen, dass die Prüfsonde 24 nicht nur in Längsrichtung der Leitung 4, sondern auch zumindest abschnittsweise in Umfangsrichtung um die Leitung 4 herum verfahren wird. Hierzu ist beispielsweise eine spiralförmig um die Leitung 4 herumlaufende Prüfbahn oder auch eine mäanderförmige Prüfbahn vorgesehen, entlang der die Prüfsonde 24 verfahren wird. Bei der mäanderförmigen Prüfbahn wird die Prüfsonde 24 abwechselnd während der Vorwärtsbewegung nach links und nach rechts geschwenkt.

Bevorzugt wird die Prüfsonde auch im Bereich der Komponente 12 an dem Gehäuse 14 entlang geführt, sodass auch die Spannungsfestigkeit des Gehäuses 14 überprüft wird.

Im oberen Teilbereich der Figur ist der Verlauf der Prüfspannung V sowie der Anpresskraft F über die Länge des Kabelsatzes 2 dargestellt. Dabei wird für jede Leitung 4 ein solcher Verlauf eingestellt und eine entsprechende Prüfung vorgenommen. Die beiden Leitungen 4 werden daher nacheinander mithilfe der von dem Roboter 20 geführten Prüfsonde 24 überprüft.

Im Ausführungsbeispiel ist für die Prüfspannung V und für die Anpresskraft F der gleiche qualitative Verlauf vorgesehen. Alternativ hierzu unterscheiden sich der Verlauf der Prüfspannung V und der Anpresskraft F voneinander.

Die Prüfung wird im Ausdrucksbeispiel von links nach rechts durchgeführt, d. h. die Prüfsonde 24 wird entlang der Leitung 4 von links nach rechts verfahren. Zu Beginn werden die Prüfspannung V sowie die Anpresskraft F auf einen jeweiligen ersten Sollwert geregelt, welcher für den normalen Abschnitt 40 gültig ist. Sobald über die Erkennungseinheit 32 erkannt wird, dass der Schutzabschnitt 8 mit der Schutzhülle 10 erreicht wird, werden die Prüfspannung V und / oder die Anpresskraft F auf einen zweiten Sollwert eingestellt, welcher im Ausführungsbeispiel höher ist als der erste Sollwert.

Nach der Prüfhülle 10 schließt sich der Anschlussabschnitt 38 an, in dem ein dritter Sollwert für die Prüfspannung V und / oder für die Anpresskraft F eingestellt wird, welcher im Ausführungsbeispiel zwischen dem für den normalen Abschnitt und dem für den Schutzabschnitt 8 liegt.

Bei dem dargestellten Ausführungsbeispiel wird die Prüfspannung V sowie auch die Anpresskraft F im Bereich des Gehäuses 14 weitgehend zurückgefahren. In diesem Fall wird keine Prüfung der Isolierung des Gehäuses 14 vorgenommen. Alternativ kann im Bereich des Gehäuses 14 jedoch auch ein weiterer Sollwert vorgegeben werden, bei dem beispielsweise die Prüfspannung V auf einen beispielsweise höchsten Sollwert geregelt wird.

Alternativ zu der zuvor beschriebenen Prüfung, bei der die Prüfsonde kontinuierlich entlang der gesamten Länge der Leitung 4 verfahren wird, ist gemäß einer alternativen Variante vorgesehen, dass spezielle, kritische Abschnitte gezielt angefahren und geprüft werden. In diesem Fall erfolgt daher eine Prüfung lediglich von einzelnen (längs-) Abschnitten (Prüfabschnitte 36) der jeweiligen Leitung 4.

Mit dem hier beschriebenen Verfahren ist eine serientaugliche (end-of line-) Überprüfung von Hochvolt-Kabelsätzen bei der Kabelsatzfertigung erreicht, über die eine zuverlässige Prüfung mit geringem Aufwand ermöglicht ist. Durch die Verwendung eines programmierbaren Roboters lassen sich unterschiedliche Kabelsatz-Designs problemlos überprüfen. Hierzu es lediglich eine Anpassung der Bewegungsbahn des Roboters erforderlich.

### Bezugszeichenliste

- 2: Kabelsatz
- 4: Leitung
- 6: Leiter
- 7: Adermantel
- 8: Schutzabschnitt
- 10: Schutzhülle
- 11: Isoliermantel
- 12: elektrische Komponente
- 14: Gehäuse
- 16: Kontaktelement
- 18: Anlage
- 20: Roboter
- 24: Prüfsonde
- 26: Steuereinheit
- 28: Prüfeinheit
- 30: Anschlussterminal
- 32: Erkennungseinheit
- 34: Kraftsensor
- 36: Prüfabschnitt
- 38: Anschlussabschnitt
- 40: normaler Abschnitt

- V: Prüfspannung
- F: Anpresskraft

## Patentansprüche

1. Verfahren zur Überprüfung der Spannungsfestigkeit einer Isolierung eines elektrischen Kabelsatzes (2), welcher zumindest eine Leitung (4) mit einem von einem Isoliermantel (11) umgebenen Leiter (6) aufweist, wobei eine Prüfsonde (24) vorgesehen ist und zwischen der Prüfsonde (24) und dem Leiter (6) eine Prüfspannung (V) angelegt wird, **dadurch gekennzeichnet, dass** die Prüfsonde (24) an einer Verstellvorrichtung (20) angebracht ist und im Rahmen eines Messzyklus die Verstellvorrichtung (20) zumindest mehrere Messpunkte am Kabelsatz (2) mit der Prüfsonde (24) anfährt und zumindest an den mehreren Messpunkten die Spannungsfestigkeit der Isolierung überprüft wird.

2. Verfahren nach dem vorhergehenden Anspruch, **dadurch gekennzeichnet, dass** die Prüfsonde (24) entlang von zumindest einem Prüfabschnitt (36) des Kabelsatzes (2) an diesem entlang verfahren wird und die Spannungsfestigkeit über die Länge des Prüfabschnittes (36) kontinuierlich überprüft wird, wobei der Prüfabschnitt (36) sich vorzugsweise über die gesamten Länge der zumindest einen Leitung (4) erstreckt.

3. Verfahren nach einem der vorhergehenden Ansprüche, **dadurch gekennzeichnet, dass** die Prüfsonde (24) mit einer definierten Anpresskraft (F) gegen die Isolierung gedrückt wird und die Anpresskraft (F) gemessen und gesteuert wird.

4. Verfahren nach einem der vorhergehenden Ansprüche, **dadurch gekennzeichnet, dass** der Wert zumindest eines Prüfparameters ausgewählt aus Prüfspannung (V) und Anpresskraft (F) während des Messzyklus variiert wird.

5. Verfahren nach dem vorhergehenden Anspruch, **dadurch gekennzeichnet, dass** der Wert des zumindest einen Prüfparameters ortsabhängig variiert wird.

6. Verfahren nach einem der vorhergehenden Ansprüche, **dadurch gekennzeichnet, dass** eine Erkennungseinheit (32) vorgesehen ist, mit deren Hilfe unterschiedliche Abschnitte (8, 38, 40) des Kabelsatzes (2) identifiziert werden, wobei es sich bei der Erkennungseinheit (32) vorzugsweise um eine Kamera handelt.

7. Verfahren nach dem vorhergehenden Anspruch und nach einem der Ansprüche 4 oder 5, **dadurch gekennzeichnet, dass** der Wert des zumindest einen Prüfparameters in Abhängigkeit der von der Erkennungseinheit (32) ermittelten Informationen eingestellt wird.

8. Verfahren nach einem der vorhergehenden Ansprüche, **dadurch gekennzeichnet, dass**
- die Leitung (4) einen Schutzabschnitt (8) aufweist, in dem die Leitung (4) eine zusätzliche Schutzhülle (10) aufweist, wobei die Anpresskraft (F) im Bereich des Schutzabschnittes (8) auf einen vorgegebenen abschnittsspezifischen Sollwert eingestellt und insbesondere erhöht wird, und / oder dass
- in einem Anschlussabschnitt (38), in dem die Leitung (4) an einer weiteren Komponente (12) angeschlossen ist, die Prüfspannung (V) auf einen vorgegebenen abschnittsspezifischen Sollwert eingestellt und insbesondere erhöht wird.

9. Verfahren nach einem der vorhergehenden Ansprüche, **dadurch gekennzeichnet, dass** die Leitung (4) als eine isolierte Busbar ausgebildet ist und einen Biegebereich aufweist, in dem die Spannungsfestigkeit geprüft wird.

10. Verfahren nach einem der vorhergehenden Ansprüche, **dadurch gekennzeichnet, dass** es sich bei dem Kabelsatz (2) um einen konfektionierten Kabelsatz (2) handelt, welcher die zumindest eine Leitung (4) und vorzugsweise zwei Leitungen (4) aufweist, wobei die zumindest eine Leitung (4) an einer weiteren Komponente (12), insbesondere an einem Stecker angeschlossen ist.

11. Verfahren nach dem vorhergehenden Anspruch, **dadurch gekennzeichnet, dass** die weitere Komponente (12) ein Gehäuse (14) aufweist und die Prüfsonde (24) auch an das Gehäuse (14) verfahren wird und die Isolationsfestigkeit des Gehäuses (14) überprüft wird.

12. Verfahren nach einem der vorhergehenden Ansprüche, **dadurch gekennzeichnet, dass** es sich bei der Verstellvorrichtung um einen Roboter (20) handelt, an dem die Prüfsonde (24) befestigt ist und dessen Bewegungsbahn programmierbar ist.

13. Anlage (18) zur Überprüfung der Spannungsfestigkeit einer Isolierung eines elektrischen Kabelsatzes (2), welcher zumindest eine Leitung (4) mit einem von einem Isoliermantel (11) umgebenen Leiter (6) aufweist, wobei die Anlage (18) aufweist
- eine Verstellvorrichtung (20), insbesondere ein programmierbarer Roboter, mit einer daran befestigten Prüfsonde (24),
- ein Anschlussterminal (30) zur elektrischen Kontaktierung des Leiters (6),
- eine Prüfeinheit (28), die zum Anlegen einer Prüfspannung (V) zwischen dem Anschlussterminal (30) und der Prüfsonde (24) ausgebildet ist,
- eine Steuereinheit (26), die dazu eingerichtet ist, die Verstellvorrichtung (20) mit der Prüfsonde (24) im Betrieb an zumindest mehrere Messpunkte am Kabelsatz (2) zu verfahren.

14. Anlage (18) nach dem vorhergehenden Anspruch, die zur Erfassung einer Anpresskraft (F) der Prüfsonde (24) sowie zur Steuerung dieser Anpresskraft (F) ausgebildet ist.

15. Anlage (18) nach einem der beiden vorhergehenden Ansprüche, die eine Erkennungseinheit (32), insbesondere eine Kamera aufweist, mit deren Hilfe unterschiedliche Abschnitte des Kabelsatzes (2) identifizierbar sind, wobei die Steuereinheit (26) und/oder die Prüfeinheit (28) derart ausgebildet sind, dass in Abhängigkeit des von der Erkennungseinheit (32) identifizierten Abschnittes (8, 38, 40) der Wert zumindest eines Prüfparameters ausgewählt aus Anpresskraft (F) und Prüfspannung (V) eingestellt wird.
